# EUROPÄISCHE PATENTSCHRIFT

(11) **EP 3 036 796 B1**
(45) Veröffentlichungstag und Bekanntmachung des Hinweises auf die Patenterteilung: **24.06.2020**
(21) Anmeldenummer: 14750755.2
(22) Anmeldetag: 14.08.2014
(51) Int. Cl.: H01R 4/242, H01R 12/53, H01R 101/00, H01R 9/22

(54) **ELEKTRISCHE KONTAKTANORDNUNG FÜR EINEN ELEKTROMOTOR UND VERFAHREN ZU DEREN HERSTELLUNG**
ELECTRICAL CONTACT ARRANGEMENT FOR AN ELECTRIC MOTOR AND METHOD FOR PRODUCING SAME
ENSEMBLE CONTACT ÉLECTRIQUE POUR UN MOTEUR ÉLECTRIQUE ET PROCÉDÉ DE FABRICATION ASSOCIÉ

(30) Priorität: 20.08.2013 DE 102013216472
(43) Veröffentlichungstag der Anmeldung: 29.06.2016
(73) Patentinhaber: Brose Fahrzeugteile SE & Co. Kommanditgesellschaft, Würzburg, 97076 Würzburg (DE)
(72) Erfinder: EHRMANN, Steffen, 97239 Aub (DE); GERLACH, Katharina, 97072 Würzburg (DE); SCHMIDT, Artur, 97082 Würzburg (DE); FLEISCHMANN, Karl-Heinz, 16348 Marienwerder (DE)
(74) Vertreter: Isarpatent
(86) Internationale Anmeldenummer: PCT/EP2014/067451
(87) Internationale Veröffentlichungsnummer: WO 2015/024867

(56) Entgegenhaltungen:
- DE-A1- 19 946 130
- DE-A1-102004 024 790
- DE-A1-102006 052 119
- DE-A1-102010 016 865
- DE-A1-102010 029 494
- DE-A1-102011 082 140
- DE-A1-102011 121 943

## Beschreibung

### GEBIET DER ERFINDUNG

Die vorliegende Erfindung betrifft eine elektrische Kontaktanordnung für einen Elektromotor und ein Verfahren zu deren Herstellung.

### TECHNISCHER HINTERGRUND

Elektrische Kontaktanordnungen für Elektromotoren existieren in den unterschiedlichsten Varianten und Ausführungsformen. Dabei hängt es unter anderem auch von der Bauweise des Elektromotors ab, welche Art von Kontaktanordnungen dafür benötigt werden.

Bei bürstenlosen Gleichstrom-Maschinen, so genannten EC (electronically commutated)-Motoren, auch BLDC-(Brushless DC) oder BL-Motoren genannt, werden so genannte Phasenkontakte benötigt. Diese erstrecken sich üblicherweise senkrecht von einem Grundleiter (einer Leiterplatte oder einem Stanzgitter), an welchem oftmals die zur Ansteuerung des Motors notwendige Leistungselektronik vorgesehen ist. Bei einer der Anmelderin bekannten Kontaktanordnung werden die Phasenkontakte an einer Leiterplatte als SMD-(Surface-mounted device) Bauelement senkrecht angelötet. Bei einer anderen der Anmelderin bekannten Kontaktanordnungen werden die Phasenkontakte aus einem Stanzgitter einteilig ausgeformt und senkrecht dazu abgewinkelt.

Eine weitere Kontaktanordnung ist in der internationalen Patentanmeldung WO 2009/112097 A1 beschrieben. Demnach erstreckt sich ein Pin durch einen Leiter hindurch und sitzt mit einem Absatz auf der Oberfläche des Leiters auf. Weitere Kontaktanordnungen werden in DE 10 2010 029494 A1, DE 19946130 A1, DE 10 2010 016865 A1, DE 10 2011 121943 A1, DE 10 2004 024790 A1, DE 10 2011 082140 A1, und DE 10 2006 052119 A1 beschrieben.

Sämtliche dieser Kontaktanordnungen sind jeweils individuell für bestimmte Leistungsklassen vorgesehen.

### ZUSAMMENFASSUNG DER ERFINDUNG

Vor diesem Hintergrund liegt der vorliegenden Erfindung die Aufgabe zugrunde, eine verbesserte Kontaktanordnung anzugeben.

Erfindungsgemäß wird diese Aufgabe durch eine Kontaktanordnung mit den Merkmalen des Patentanspruchs 1 und durch ein Verfahren mit den Merkmalen des Patentanspruches 9 gelöst.

Demgemäß ist vorgesehen:
- Eine Elektrische Kontaktanordnung mit den Merkmalen des Patentanspruchs 1. und ein- Ein Verfahren mit den Merkmalen des Patentanspruches 9.

Die der vorliegenden Erfindung zugrunde liegende Idee besteht darin, einen (Phasen-)Kontakt mit einer kraft- und/oder form- und/oder stoffschlüssigen 90° Verbindung an ein Stanzgitter anzubringen. Auf diese Weise ist es möglich, ein Universalstanzgitter bei Phasenkontakten einzusetzen und diese im Baukastensystem miteinander zu verbinden. Vorteilhaft können somit Einzelteile in höherer Anzahl und aufgrund von Mengeneffekten wirtschaftlicher gefertigt werden.

Ferner wird somit ein einheitlicher Fertigungsprozess für unterschiedliche Leitungsklassen, insbesondere für alle Leistungsklassen von KFZ-Lüfterantrieben, geschaffen, wodurch Synergien bei der Herstellung der verschiedenen Leistungsklassen besser nutzbar sind.

Vorteilhafte Ausgestaltungen und Weiterbildungen ergeben sich aus den weiteren Unteransprüchen sowie aus der Beschreibung unter Bezugnahme auf die Figuren der Zeichnung.

Beispielsweise weist die leitende Verbindung am Kontakt zumindest einen Steckfortsatz und am Stanzgitter zumindest eine zu dem Steckfortsatz korrespondierende Ausnehmung auf, wobei der Steckfortsatz in der Ausnehmung mittels einer Presspassung befestigt ist. Zur Befestigung wird bevorzugt ein Pressfit-Verfahren eingesetzt, wobei die Ausnehmung bevorzugt in Form einer Bohrung vorliegt und der Steckfortsatz bevorzugt eine rechteckige Querschnittsfläche aufweist. Somit werden beim Pressfit-Verfahren die Ecken der Querschnittsfläche des Steckfortsatzes leicht verformt, wodurch ein Kraftschluss zwischen Steckfortsatz und Ausnehmung des Stanzgitters zustande kommt. Alternativ ist es auch denkbar, einen klassischen zylindrischen Presssitz vorzusehen.

Beispielsweise weist die leitende Verbindung eine im Stanzgitter planar geformte Gabel auf, in welche der Kontakt eingeführt und darin befestigt ist. Bevorzugt wird der Kontakt in der Gabel heißverstemmt. Beim Heißverstemmen, welches auch als Warmverstemmen bezeichnet wird, wird eine dauerhafte formschlüssige, kraftschlüssige und teilweise darüber hinaus stoffschlüssige Verbindung geschaffen. Die Gabel wird dabei unter Anwendung von Presskraft und Wärme angeschmolzen und umgeformt. Alternativ zum Heißverstemmen wäre auch eine Lötverbindung oder eine klassische Schweißverbindung, beispielsweise mittels Laserstrahlschweißen oder Widerstandsschweißen denkbar.

Beispielsweise ist die Gabel einteilig mit dem Stanzgitter ausgebildet und weist einen Stiel auf, mittels dem sie am Stanzgitter angebunden ist. Somit ist vorteilhaft kein weiteres Befestigungsmittel zur Anbindung des Kontakts an das Stanzgitter nötig.

Beispielsweise ist der Stiel Z-förmig doppelt abgewinkelt ausgebildet. Optional oder zusätzlich ist die Gabel parallel zum Stanzgitter angeordnet. Durch die Z-förmige Abwinkelung des Stiels wird ein Versatz zwischen der Ebene des Stanzgitters und der Ebene der Gabel erreicht, wodurch die Zugänglichkeit der Gabel für den Befestigungsprozess, insbesondere den Heißverstemmprozess, verbessert wird. Bei der Z-Form können die Büge auch rechtwinklig sein. Die Parallelität der Gabel zum Stanzgitter ist bei dieser Ausführungsform bevorzugt, da dadurch automatisch eine senkrechte Ausrichtung des Kontakts zum Stanzgitter erreicht wird. Alternativ zu einer Beabstandung durch einen Z-förmig abgewinkelten Stiel wäre es auch denkbar, eine vergrößerte Ausnehmung im Stanzgitter um den Bereich der Gabel vorzusehen, so dass die Gabel mit einem Werkzeug zum Verbinden der Gabel mit dem Kontakt erreichbar ist.

Die leitende Verbindung weist einen vom Kontakt senkrecht abgewinkelten Kontaktfuß auf. Dieser erstreckt sich parallel zum Stanzgitter und ist daran flächig angeschweißt. Somit wird vorteilhaft am Kontakt eine Anbindungsfläche bereitgestellt, bei der bereits eine bevorzugte Ausrichtung des Kontakts senkrecht zum Stanzgitter vorgesehen ist. Zum Anschweißen des Kontaktfußes an das Stanzgitter wird bevorzugt ein Buckelschweißverfahren eingesetzt, bei welchem ein buckelförmiger Fortsatz am Kontaktfuß vorgesehen ist und der Kontaktfuß mittels Widerstandsschweißen angeschweißt wird. Durch den buckelförmigen Fortsatz wird ein punktförmiger Anlagepunkt geschaffen, wodurch nur eine sehr geringe Anlagefläche des Buckels am Stanzgitter besteht. Somit wird der Widerstand des Übergangs erhöht, wodurch das Material des Kontaktfußes, welches bevorzugt Kupfer enthält, leichter zum Herstellen einer Schweißverbindung aufgeschmolzen werden kann. Nach dem Anschweißen steht dann vorteilhaft eine sehr große Kontaktfläche zwischen Kontakt und Stanzgitter zur Verfügung, die insbesondere größer als die mathematische Schnittfläche zwischen den Geometrien des Kontakts und des Stanzgitters ist. Alternativ zum Buckelschweißen wäre es auch denkbar, den Kontaktfuß am Stanzgitter mittels eines anderen Widerstandsschweißverfahrens, eines Laserstrahlschweißverfahrens, eines MIG (Metall Inert Gas)-Schweißverfahrens, eines Lötverfahrens oder dergleichen anzubinden. Ferner wäre auch eine Anbindung mittels eines Verbindungsmittels denkbar, beispielsweise einer durch den Kontaktfuß und das Stanzgitter getriebenen Niete.

Erfindungsgemäß ist der Kontaktfuß durch das Stanzgitter hindurchgeführt und kontaktiert das Stanzgitter mit seiner zum Kontakt orientierten Seite. Die zum Kontakt orientierte Seite entspricht der Seite, welche zur Erstreckungsrichtung des Kontakts orientiert ist. Vorteilhaft können somit insbesondere Zugbelastungen in Erstreckungsrichtung des Kontakts besonders gut aufgenommen werden. Ferner ist die Verbindungsstelle somit vom Elektromotor abgeschirmt. Dies kann insbesondere dann vorteilhaft sein, wenn es sich um ein umspritztes Stanzgitter handelt, bei welchem die zur Kontaktierung vorgesehene Fläche von der Umspritzung ausgespart ist. Die Umspritzung ist als Kunststoffschicht ausgebildet und zum Korrosionsschutz und zur Isolation des Stanzgitters ausgelegt und vorgesehen. Die nicht isolierte Kontaktstelle ist dann vorteilhaft an der geschützten Rückseite des Stanzgitters vorgesehen.

Bei einem weiteren Beispiel ist der Kontaktfuß an seiner entgegen dem Kontakt orientierten Seite auf dem Stanzgitter stehend kontaktiert. Dabei steht der Kontaktfuß mit seiner "Sohle", also der Seite des Kontaktfußes, welche der Erstreckungsrichtung des Kontakts abgewandt orientiert ist, auf dem Stanzgitter auf. Vorteilhaft ist der Kontaktfuß somit frei auf dem Stanzgitter positionierbar, wobei der senkrechte Winkel stets erhalten bleibt. Ferner ist kein Durchbruch im Stanzgitter notwendig.

Beispielsweise weist die leitende Verbindung eine im Stanzgitter geformte Lasche auf, welche einen senkrecht zum Stanzgitter aufgestellten Rücken und zwei senkrecht zum Rücken abgewinkelte Laschenflügel aufweist. Der Kontakt ist dabei zwischen den Laschenflügeln in die Lasche eingeführt und darin befestigt, insbesondere heißverstemmt. Durch die Lasche wird vorteilhaft eine senkrecht zur Ebene des Stanzgitters orientierte Befestigungsführung geschaffen, welche besonders vorteilhaft eine sehr große Kontaktfläche zwischen dem Kontakt und dem Stanzgitter bereitstellt, die insbesondere großer als die mathematische Schnittfläche zwischen den Geometrien des Kontakts und des Stanzgitters ist. Die Laschenflügel und der Rücken umschließen dabei den Kontakt U-förmig. Durch das Heißverstemmen wird auch noch bevorzugt die offene Seite der U-Form geschlossen, so dass der Kontakt, insbesondere vollständig, umschlossen wird. Selbstverständlich sind auch dabei die oben genannten alternativen Verbindungsprozesse, welche alternativ zum Heißverstemmen eingesetzt werden können, möglich.

Beispielsweise ist die Lasche einteilig mit dem Stanzgitter ausgebildet und weist einen mit dem Rücken verbundenen Stiel auf, mittels dem sie am Stanzgitter angebunden ist. Besonders bevorzugt kann die Lasche in ihrer abgewickelten Fläche beim Herstellungsprozess des Stanzgitters mit ausgebildet werden. Anschließend wird sie mittels eines Umformprozesses in ihre endgültige Form gebracht. Vorteilhaft ist die Lasche dabei durch den Stiel bereits am Stanzgitter angebunden, so dass keine zusätzliche Verbindungstechnik notwendig ist. Auf den Herstellungsprozess zum Ausbilden der Lasche wird weiter unten noch im Detail eingegangen.

Bei einem Beispiel eines Verfahrens zur Herstellung einer elektrischen Kontaktanordnung wird die Verbindung zwischen zumindest einem am Kontakt geformten Steckfortsatz und zumindest einer im Stanzgitter vorgesehenen Ausnehmung mittels einer Presspassung hergestellt. Bevorzugt kommt hierbei das oben bereits beschriebene Pressfit-Verfahren zum Einsatz. Somit wird eine Verbindung geschaffen, ohne dass dafür eine thermische Einwirkung notwendig ist. Ferner sind keine zusätzlichen Hilfsstoffe (Lot, Flussmittel, Sil-fos, oder dergleichen) nötig. Ferner wird dabei vorteilhaft die werkzeuggebundene Kontur des Kontakts ohne einen zusätzlichen Biegeprozess direkt bereitgestellt.

Bei einem weiteren Beispiel des Verfahrens wird die Verbindung mittels einer flach im Stanzgitter ausgeformten Gabel, welche einen Stiel aufweist, mittels dem sie am Stanzgitter angebunden ist, mit den folgenden Schritten hergestellt: Doppeltes, insbesondere Z-förmiges, Abwinkeln des Stiels derart, dass die Gabel beabstandet und parallel zum Stanzgitter angeordnet wird; Einführen des Kontakts in die Gabel; Heißverstemmen der Gabel und des Kontakts. Besonders vorteilhaft bei dieser Ausführungsform ist, dass ein Rundkontakt schweißtechnisch damit sehr einfach an das Stanzgitter angebunden bzw. damit verbunden werden kann. Vorteilhaft kann dabei die werkzeuggebundene Kontur des Kontakts ohne zusätzlichen Biegeprozess bereitgestellt werden. Bevorzugt ist die Gabel dabei derart ausgeformt, dass der Kontakt vor dem Heißverstemmen mit einer Spielpassung in die Gabel eingelegt werden kann, so dass das Einlegen vorteilhaft leicht durchführbar ist. Beim Heißverstemmen der Gabel und des Kontakts wird bevorzugt eine formschlüssige, kraftschlüssige und teilweise darüber hinaus auch stoffschlüssige Verbindung geschaffen. Beispielsweise wird dazu eine heiße Presszange an der Gabel angelegt, mittels welcher gleichzeitig Hitze und eine Presskraft auf die Gabel übertragen werden. Dabei schmilzt das Material der Gabel teilweise an bzw. auf und wird gleichzeitig zum Befestigen des Kontakts umgeformt.

Bei einem erfindungsgemäßen Verfahren wird die Verbindung mittels eines am Kontakt angeformten, senkrecht dazu abgewinkelten Kontaktfußes, welcher sich parallel zum Stanzgitter erstreckt, mit den folgenden Schritten hergestellt: Durchführen des Kontaktfußes durch eine Öffnung im Stanzgitter und Anlegen der zum Kontakt orientierten Fläche des Kontaktfußes an das Stanzgitter, oder Aufsetzen der entgegen dem Kontakt orientierten Fläche des Kontaktfußes auf das Stanzgitter; Schweißen, insbesondere Buckelschweißen, des Kontaktfußes an das Stanzgitter. Beim Kontakt kann es sich insbesondere um ein Rundkontaktelement handeln, welches im Bereich des Kontaktfußes flach umgeformt und abgewinkelt wurde. Somit wird das Rundkontaktelement mit einer sehr großen Kontaktfläche am Stanzgitter angebunden, wodurch die Verbindung eine hohe mechanische Stabilität und eine hohe elektrische Leitfähigkeit erhält. Alternativ dazu wäre es auch denkbar, dass der Kontakt eine rechteckige Querschnittsfläche aufweist und der Kontaktfuß lediglich einen abgewinkelten Abschnitt des Kontakts darstellt. Bei der ersten Alternative des Verfahrens (Durchführen) ist es vorteilhaft, dass die Verbindung hohe Zugkräfte in Erstreckungsrichtung des Kontakts aufnehmen kann. Bei der zweiten Alternative des Verfahrens (Aufsetzen) ist besonders vorteilhaft, dass der Kontakt ohne Durchbruch im Stanzgitter mit diesem mit einer großen Kontaktfläche verschweißt werden kann.

Bei einem weiteren Beispiel des Verfahrens wird die Verbindung mittels einer einteilig im Stanzgitter geformten Lasche, die einen Rücken, insbesondere auch einen mit dem Rücken verbundenen Stiel, mittels dem die Lasche am Stanzgitter angebunden ist, und zwei senkrecht zum Rücken abgewinkelte Laschenflügel aufweist, mit den folgenden Schritten hergestellt: Senkrechtes Aufstellen des Rückens gegenüber dem Stanzgitter; senkrechtes Abwinkeln der Laschenflügel gegenüber dem Rücken; Einführen des Kontakts in die Lasche zwischen die Laschenflügel; Heißverstemmen der Lasche und des Kontakts. Bevorzugt wird beim senkrechten Abwinkeln der Laschenflügel gegenüber dem Rücken eine Lücke zwischen den in gleicher Richtung abgewinkelten Laschenflügeln bereitgestellt, in welche der Kontakt mit einer Spielpassung einlegbar ist. Beim Heißverstemmen der Lasche mit dem Kontakt wird dann eine formschlüssige, kraftschlüssige und zumindest teilweise auch stoffschlüssige Verbindung zwischen der Lasche und dem Kontakt geschaffen. Auch bei dieser Verbindungstechnik wird eine im Vergleich zur Querschnittsfläche des Kontakts sehr große Kontaktfläche zwischen dem Stanzgitter und dem Kontakt bei gleichzeitig einfacher Geometrie des Kontakts realisiert, was hinsichtlich der mechanischen Festigkeit und der elektrischen Leitfähigkeit eine verbesserte Verbindung bereitstellt.

Die obigen Ausgestaltungen und Weiterbildungen lassen sich, sofern sinnvoll, beliebig miteinander kombinieren. Weitere mögliche Ausgestaltungen, Weiterbildungen und Implementierungen der Erfindung umfassen auch nicht explizit genannte Kombinationen von zuvor oder im Folgenden bezüglich der Ausführungsbeispiele beschriebenen Merkmale der Erfindung. Insbesondere wird dabei der Fachmann auch Einzelaspekte als Verbesserungen oder Ergänzungen zu der jeweiligen Grundform der vorliegenden Erfindung hinzufügen.

### INHALTSANGABE DER ZEICHNUNG

Die vorliegende Erfindung wird nachfolgend anhand der in den schematischen Figuren der Zeichnung angegebenen Ausführungsbeispiele näher erläutert. Es zeigen dabei:
- Fig. 1: eine perspektivische Vorderansicht einer elektrischen Kontaktanordnung im Pressfit-Design;
- Fig. 2: eine perspektivische Vorderansicht einer elektrischen Kontaktanordnung mit einer im Stanzgitter ausgeformten Gabel;
- Fig. 3: eine perspektivische Vorderansicht einer elektrischen Kontaktanordnung mit am Kontakt geformtem Kontaktfuß in einer ersten Variante;
- Fig. 4: eine perspektivische Ansicht von unten auf eine elektrische Kontaktanordnung mit einem am Kontakt geformten Kontaktfuß in einer zweiten Variante;
- Fig. 5a: eine perspektivische Vorderansicht einer elektrischen Kontaktanordnung mit einer im Stanzgitter ausgeformten Lasche;
- Fig. 5b: eine Draufsicht auf die im Stanzgitter geformte Lasche in einem abgewickelten Zustand.

Die beiliegenden Figuren der Zeichnung sollen ein weiteres Verständnis der Ausführungsformen der Erfindung vermitteln. Sie veranschaulichen Ausführungsformen und dienen im Zusammenhang mit der Beschreibung der Erklärung von Prinzipien und Konzepten der Erfindung. Andere Ausführungsformen und viele der genannten Vorteile ergeben sich im Hinblick auf die Zeichnungen. Die Elemente der Zeichnungen sind nicht notwendigerweise maßstabsgetreu zueinander gezeigt.

In den Figuren der Zeichnung sind gleiche, funktionsgleiche und gleich wirkende Elemente, Merkmale und Komponenten - sofern nichts anderes ausgeführt ist - jeweils mit denselben Bezugszeichen versehen.

### BESCHREIBUNG VON AUSFÜHRUNGSBEISPIELEN

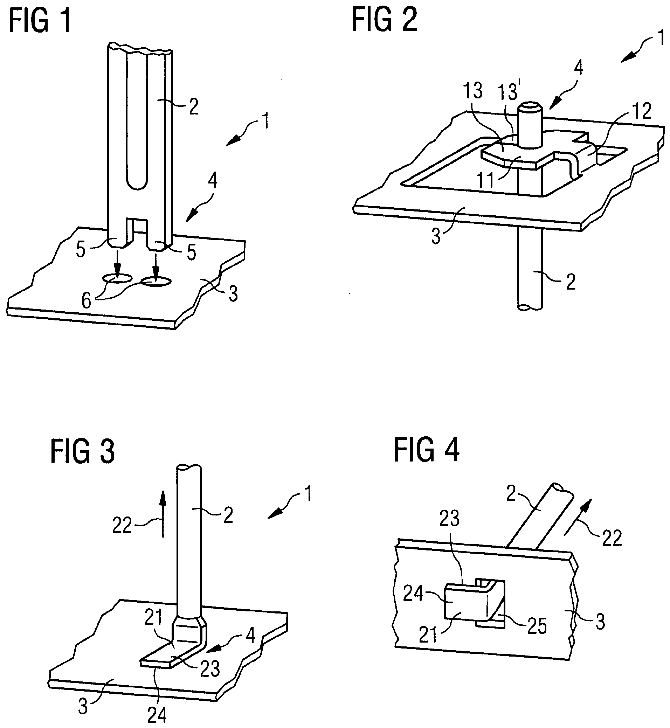

Figur 1 zeigt eine perspektivische Vorderansicht einer elektrischen Kontaktanordnung 1 im Pressfit-Design. Die elektrische Kontaktanordnung 1 weist ein Stanzgitter 3 und einen Kontakt 2 auf. Beim Stanzgitter 3 handelt es sich um ein umspritztes Stanzgitter, wobei das Grundmaterial ein leitfähiges Metall, insbesondere Kupfer, bevorzugt E-Cu, ist und diese leitende Schicht mit einem nicht dargestellten Kunststoffmantel umspritzt ist. Beim Kontakt handelt es sich ebenfalls um ein leitendes Material, insbesondere Kupfer, bevorzugt E-Cu. Eine leitende Verbindung 4 weist in der dargestellten Ausführungsform zwei Steckfortsätze 5 am Kontakt 2 auf, welche jeweils eine quadratische Querschnittsfläche aufweisen. Ferner sind im Stanzgitter 3 zwei korrespondierend zu den Steckfortsätzen 5 ausgebildete Ausnehmungen 6 vorgesehen. In der dargestellten Ausführungsform sind dies Bohrungen bzw. Rundlöcher. Im Bereich der Verbindung 4 ist ein etwaiger Kunststoffmantel ausgenommen.

Zur Befestigung des Kontakts 2 am Stanzgitter 3 werden die Steckfortsätze 5 in die Ausnehmungen 6 eingepresst. Somit entsteht eine kraftschlüssige Verbindung zwischen Stanzgitter 3 und Kontakt 2, wobei sich das Material des Kontakts 2 und/oder des Stanzgitters 3 im Bereich der Ecken der Steckfortsätze 5 verformt und somit eine Normalkraft auf die Kontaktfläche ausgeübt wird, wodurch ein Reibschluss entsteht. Die Verbindung besteht somit in einem Kraftschluss an den Kontaktflächen zwischen Kontakt 2 und Stanzgitter 3.

Figur 2 zeigt eine perspektivische Vorderansicht einer elektrischen Kontaktanordnung 1 mit einer im Stanzgitter 3 ausgeformten Gabel 11. Das Stanzgitter 3 wird dazu schon beim Ausstanzen mit der darin integrierten Gabel 11 in einer gemeinsamen Ebene geformt. Die Gabel 11 weist zwei Gabelfortsätze 13, 13' und einen Stil 12 auf. Im nicht dargestellten Rohzustand des Stanzgitters 3 erstreckt sich die Gabel 11 in der Ebene des Stanzgitters 3, wobei der Stil 12 flach und die Gabelfortsätze 13, 13' ebenfalls flach und beabstandet zueinander in der Ebene des Stanzgitters 3 verlaufen. Anschließend wird der Stil 12 der Gabel 11 in der in Figur 2 gezeigten Weise Z-förmig doppelt umgebogen, so dass sich die Gabel 11 in einer Ebene parallel zur Ebene des Stanzgitters 3 erstreckt. Dies dient der besseren Zugänglichkeit der Gabel 11 mit einem Heißverstemmwerkzeug. Bei den Z-Bügen handelt es sich bevorzugt um rechtwinklige Büge.

Mit einer solchen Gabel 11 kann ein Kontakt 2, insbesondere ein Rundkontakt, welcher sich senkrecht zur Ebene des Stanzgitters 3 erstreckt, an dem Stanzgitter 3 in einem 90°-Winkel befestigt werden. Dazu wird der Kontakt 2 zwischen die beiden Gabelfortsätze 13, 13' eingeführt. Anschließend wird die Gabel 11, insbesondere die Gabelfortsätze 13, 13' mit einem Heißverstemmwerkzeug erhitzt und verquetscht, so dass eine formschlüssige, kraftschlüssige und zumindest teilweise auch stoffschlüssige Verbindung zwischen dem Kontakt 2 und der Gabel 11 hergestellt wird. Somit wird der in Figur 2 dargestellte Zustand erreicht, in welchem der Kontakt 2 in der Gabel 11 mittels Heißverstemmen befestigt ist und somit eine leitende Verbindung 4 zwischen dem Kontakt 2 und dem Stanzgitter 3 hergestellt.

Figur 3 zeigt eine perspektivische Vorderansicht einer elektrischen Kontaktanordnung 1 mit am Kontakt 2 geformtem Kontaktfuß 21 in einer ersten Variante. Der Kontakt 2 ist als Rundkontakt ausgebildet und ist in einem 90° Winkel zum Stanzgitter 3 angeordnet. Der Kontaktfuß 21 ist an einem abgeflachten Ende des Rundkontaktes 2 gebildet und zu der Erstreckungsrichtung 22 des Kontakts 2 senkrecht abgewinkelt. Der Kontaktfuß 21 weist eine dem Kontakt bzw. der Erstreckungsrichtung 22 des Kontakts 2 zugewandte Seite 23 und eine dem Kontakt bzw. dessen Erstreckungsrichtung abgewandte Seite 24 auf. In der dargestellten Ausführungsform steht der Kontakt 2 mit der abgewandten Seite 24, welche sozusagen die Sohle des Kontaktfußes 21 bildet, auf dem Stanzgitter 3 auf. Die elektrisch leitende Verbindung 4 zwischen dem Kontaktfuß 21 und dem Stanzgitter 3 wird durch Anschweißen des Kontaktfußes 21 an das Stanzgitter 3 hergestellt. Besonders bevorzugt wird dazu ein Buckelschweißverfahren eingesetzt. Alternativ dazu kann auch ein anderes Widerstandsschweißverfahren, ein Laserstrahlschweißverfahren, oder ein Lötprozess zur stoffschlüssigen Verbindung des Kontaktfußes 21 mit dem Stanzgitter 3 eingesetzt werden. Bevorzugt wird dabei die abgewandte Seite 24 großflächig an das Stanzgitter angeschweißt, so dass eine große Kontaktfläche entsteht, welche eine hohe mechanische Festigkeit und eine hohe elektrische Leitfähigkeit aufweist.

Figur 4 zeigt eine perspektivische Unterseitenansicht einer elektrischen Kontaktanordnung 1 mit am Kontakt 2 angeformtem Kontaktfuß 21 in einer erfindungsgemäßen Variante. Dabei erstreckt sich der Kontakt 2 senkrecht zur Ebene des Stanzgitters 3 und weist einen analog zum in Figur 3 gezeigten Kontaktfuß 21 geformten Kontaktfuß 21 auf. Im Unterschied zur in Figur 3 gezeigten Anordnung wird der Kontaktfuß 21 in der dargestellten Ausführungsform durch eine Ausnehmung 25 im Stanzgitter 3 durch das Stanzgitter 3 hindurchgeführt und an der Rückseite des Stanzgitters 3 befestigt. Dazu liegt der Kontaktfuß 21 mit seiner dem Kontakt 2 bzw. der Erstreckungsrichtung 22 des Kontakts 2 zugewandten Seite 23 an dem Stanzgitter 3 an und ist damit großflächig verschweißt. Analog zur in Bezug auf Figur 3 beschriebenen Ausführungsform können auch hier unterschiedlichste Fügetechniken eingesetzt werden, wobei bevorzugt ein Buckelschweißprozess eingesetzt wird. Die Ausnehmung 25 zum Durchführen des Kontaktfußes 21 wird bevorzugt bereits beim Stanzen des Stanzgitters 3 eingebracht, so dass dafür kein zusätzlicher Fertigungsschritt notwendig ist.

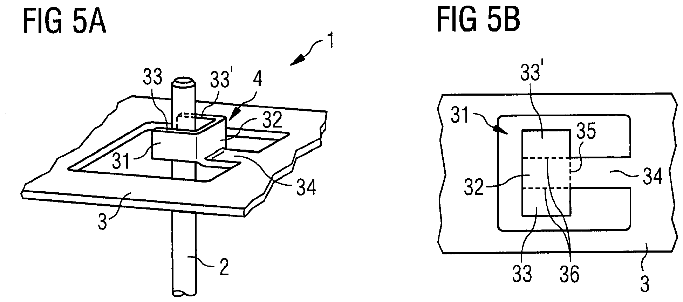

Figur 5a zeigt eine perspektivische Vorderansicht einer elektrischen Kontaktanordnung mit einer im Gitter geformten Lasche 31. In dieser Ausführungsform ist der Kontakt 2, welcher als Rundkontakt ausgebildet ist, ebenfalls senkrecht zum Stanzgitter 3 ausgerichtet. Die Lasche 31 ist einteilig mit dem Stanzgitter 3 ausgebildet und in dem Herstellungsprozess des Stanzgitters 3 integriert hergestellt. Dazu wird eine abgewickelte Fläche der Lasche 31 beim Stanzen des Stanzgitters 3 mit ausgestanzt und anschließend durch Umformen zu einer Lasche 31 gebogen. Die Lasche 31 weist zwei Laschenflügel 33, 33', einen Rücken 32 sowie einen Stil 34 auf. Der Stil 34 ist mit dem Rücken 32 und mit dem restlichen Stanzgitter 3 verbunden. Der Rücken 32 ist senkrecht zum Stil 34 abgewinkelt und verläuft parallel zum Kontakt 2. Wiederum senkrecht zum Rücken sind in gleicher Richtung die Laschenflügel 33, 33' abgewinkelt und verlaufen ebenfalls parallel zum Kontakt 2. Zum Schaffen einer elektrisch leitenden Verbindung 4 zwischen dem Stanzgitter 3 und dem Kontakt 2 wird der Kontakt 2 zwischen die Laschenflügel 33, 33' in die Lasche 31 eingeführt. Die Laschenflügel 33, 33' sind dazu bevorzugt mit einem größeren Abstand zueinander vorgesehen, als der Durchmesser des Kontakts 2 einnimmt, so dass der Kontakt 2 mit einer Spielpassung leicht in die Lasche 31 eingebracht werden kann. Anschließend werden die Laschenflügel 33, 33' bzw. die Lasche 31 mit dem Kontakt 2 heißverstemmt, wobei insbesondere die Laschenflügel 33, 33' umgeformt werden. Somit wird eine kraft- und formschlüssige sowie teilweise stoffschlüssige Verbindung zwischen dem Kontakt 2 und der Lasche 31 hergestellt.

Aufgrund dessen, dass die Lasche den Kontakt 2 im fertig montierten Zustand größtenteils bzw. bevorzugt sogar vollständig umschließt, wird eine besonders große Kontaktfläche zwischen dem Kontakt 2 und dem Stanzgitter 3 bereitgestellt, wodurch die mechanische Stabilität der Verbindung 4 sowie die elektrische Leitfähigkeit vorteilhaft vergleichsweise hoch sind.

Figur 5b zeigt eine Draufsicht auf das Stanzgitter 3 und die Lasche 31 gemäß Figur 5a in einem nicht umgeformten, abgewickelten Zustand. Dieser abgewickelte Zustand entspricht einem Rohzustand, welcher vor dem Umformen der Lasche 31 vorliegt. Zur Herstellung der Lasche 31 wird diese abgewickelte Form beim Stanzen des Stanzgitters 3 geformt. Dabei sind der Stiel 34, der Rücken 32 und die Laschenflügel 33, 33' in einer Ebene mit dem restlichen Stanzgitter 3 angeordnet. Zum Formen der Lasche 31 wird dann zunächst der Rücken 32 gegenüber dem Stiel 34 entlang einer ersten Biegelinie 35 senkrecht umgebogen, so dass der Rücken 32 sich senkrecht aus der Ebene des Stanzgitters 3 erstreckt. Anschließend werden relativ zum Rücken 32 die Laschenflügel 33, 33' entlang zweiter Biegelinien 36 senkrecht abgewinkelt, wobei beide Laschenflügel 33, 33' in dieselbe Richtung vom Stiel 34 abgewandt abgewinkelt werden. Somit entsteht eine U-Form der Lasche 31, welche senkrecht zur Ebene des Stanzgitters 3 orientiert ist. Zum Verbinden des Kontakts 2 mit dem Stanzgitter 3 wird der Kontakt 2 senkrecht zum Stanzgitter 3 in die Lasche 31 zwischen die Laschenflügel 33, 33' eingeführt. Anschließend wird er wie in Bezug auf Figur 5a beschrieben mit der Lasche 31 befestigt.

### Bezugszeichenliste

- 1: Kontaktanordnung
- 2: Kontakt
- 3: Grundleiter, Stanzgitter
- 4: Verbindung
- 5: Steckfortsatz
- 6: Ausnehmung

- 11: Gabel
- 12: Stiel
- 13, 13': Gabelfortsätze

- 21: Kontaktfuß
- 22: Erstreckungsrichtung des Kontakts
- 23: zum Kontakt orientierten Seite
- 24: entgegen dem Kontakt orientierte Seite
- 25: Ausnehmung

- 31: Lasche
- 32: Rücken
- 33, 33': Laschenflügel
- 34: Stiel
- 35: erste Biegelinie
- 36: zweite Biegelinien

## Patentansprüche

1. Elektrische Kontaktanordnung (1) für einen Elektromotor, mit einem länglich ausgebildeten Kontakt (2), der senkrecht zu einem planar ausgebildeten Grundleiter (3) verläuft, wobei der Grundleiter (3) als Stanzgitter (3) ausgebildet ist, wobei eine leitende stoffschlüssige Verbindung (4) zwischen dem Stanzgitter (3) und dem Kontakt (2) vorgesehen ist, wobei die leitende Verbindung (4) einen vom Kontakt (2) senkrecht abgewinkelten Kontaktfuß (21) aufweist, welcher sich parallel zum Stanzgitter (3) erstreckt und daran flächig angeschweißt ist, wobei der Kontakt (2) durch das Stanzgitter (3) hindurchgeführt ist und der Kontaktfuß (21) das Stanzgitter (3) mit seiner zum Kontakt (2) orientierten Seite (23) kontaktiert.

2. Kontaktanordnung nach Anspruch 1, wobei ein Material des Kontaktfußes Kupfer enthält.

3. Kontaktanordnung nach Anspruch 2, wobei der Kontaktfuß durch ein Widerstandsschweißverfahren angebunden ist.

4. Kontaktanordnung nach Anspruch 2, wobei der Kontaktfuß durch Buckelschweißen angeschweißt ist.

5. Kontaktanordnung nach Anspruch 4 wobei nach dem Anschweißen eine Kontaktfläche zwischen Kontakt und Stanzgitter größer als die mathematische Schnittfläche zwischen den Geometrien des Kontakts und des Stanzgitters ist.

6. Kontaktanordnung nach Anspruch 2, wobei der Kontaktfuß mittels eines Laserstrahlschweißverfahrens oder mittels eines Metall-Inert-Gas-Schweißverfahrens angebunden ist.

7. Kontaktanordnung nach einem der vorangehenden Ansprüche, wobei das Stanzgitter als umspritztes Stanzgitter ausgebildet ist, bei welchem die zur Kontaktierung vorgesehene Fläche von der Umspritzung ausgespart ist.

8. Kontaktanordnung nach Anspruch 7, wobei die Umspritzung als Kunststoffschicht ausgebildet ist.

9. Verfahren zur Herstellung einer elektrischen Kontaktanordnung (1), mit den Schritten:
Bereitstellen eines ebenen Stanzgitters (3) und eines länglich ausgebildeten Kontakts (2);
Senkrechtes Anordnen des Kontakts (2) zum Stanzgitter (3);
Herstellen einer leitenden stoffschlüssigen Verbindung (4) zwischen Kontakt (2) und Stanzgitter (3),
wobei die Verbindung (4) mittels eines am Kontakt (2) angeformten, senkrecht dazu abgewinkelten Kontaktfußes (21), welcher sich parallel zum Stanzgitter (3) erstreckt, mit den folgenden Schritten hergestellt wird:
Durchführen des Kontaktfußes (21) durch eine Öffnung (25) im Stanzgitter (3) und Anlegen der zum Kontakt (2) orientierten Fläche (23) des Kontaktfußes (21) an das Stanzgitter (3);
Schweißen des Kontaktfußes (21) an das Stanzgitter (3).

10. Verfahren nach Anspruch 9, wobei der Kontaktfuß durch Buckelschweißen an das Stanzgitter geschweißt wird.

11. Verfahren nach Anspruch 9 oder 10, wobei als Kontakt ein Rundkontaktelement vorgesehen wird, welches im Bereich des Kontaktfußes flach umgeformt und abgewinkelt wurde.

## Claims

1. Electrical contact arrangement (1) for an electric motor, having an elongate contact (2) which is extending perpendicular to a planar base conductor (3), said base conductor being provided as a lead frame (3), wherein a conductive material bond (4) is provided between the lead frame (3) and the contact (2), wherein the conductive bond (4) has a contact base (21) angled perpendicular to the contact (2) and extending parallel to the lead frame (3) and being welded flush thereto, wherein the contact (2) is guided through the lead frame (3) and the contact base (21) is in contact with the lead frame (3) via the face (23) that is oriented towards the contact (2).

2. Contact arrangement according to claim 1, wherein a material of the contact base contains copper.

3. Contact arrangement according to claim 2, wherein the contact base is attached by means of a resistance welding method.

4. Contact arrangement according to claim 2, wherein the contact base is welded on by means of projection welding.

5. Contact arrangement according to claim 4, wherein after welding a contact surface between the contact and lead frame is larger than the mathematical plane of section between the geometries of the contact and lead frame.

6. Contact arrangement according to claim 2, wherein the contact base is attached by means of a laser beam welding process or metal-inert-gas welding process.

7. Contact arrangement according to any one of the preceding claims, wherein the lead frame is provided as an overmoulded lead frame in which the surface for contacting is omitted from the overmoulding.

8. Contact arrangement according to claim 7, wherein the overmoulding is provided as a plastic coating.

9. Method for producing an electrical contact arrangement (1), presenting the steps:
provision of a flat lead frame (3) and an elongate contact (2) ;
perpendicular arrangement of the contact (2) relative to the lead frame (3);
producing of a conductive material bond (4) between the contact (2) and lead frame (3),
wherein the bond (4) is made by means of a contact base (21) shaped to fit the contact (2) and angled perpendicular thereto, said contact base (21) extending parallel to the lead frame (3) and achieved by the following steps:
guiding the contact base (21) through an opening (25) in the lead frame (3) and placing the surface (23) of the contact base (21) oriented towards the contact (2) against the lead frame (3);
welding the contact base (21) to the lead frame (3).

10. Method according to claim 9, wherein the contact base is welded to the lead frame by means of projection welding.

11. Method according to claim 9 or 10, wherein a round contact element is provided as the contact which has been shaped flat and angled away in the region of the contact base.

## Revendications

1. Agencement de contact électrique (1) pour un moteur électrique, comportant un contact de forme allongée (2) qui s'étend perpendiculairement à un conducteur de base (3) de forme plane, le conducteur de base (3) étant réalisé sous la forme d'une grille de connexion estampée (3), une liaison par matière conductrice (4) étant prévue entre la grille de connexion estampée (3) et le contact (2), la liaison conductrice (4) présentant un pied de contact (21) coudé perpendiculairement au contact (2), qui s'étend parallèlement à la grille de connexion estampée (3) et est soudé à plat sur celle-ci, le contact (2) étant passé à travers la grille de connexion estampée (3) et le pied de contact (21) étant en contact avec la grille de connexion estampée (3) par son côté (23) orienté vers le contact (2).

2. Agencement de contact selon la revendication 1, dans lequel un matériau du pied de contact contient du cuivre.

3. Agencement de contact selon la revendication 2, dans lequel le pied de contact est relié par un procédé de soudage par résistance.

4. Agencement de contact selon la revendication 2, dans lequel le pied de contact est soudé par bossages.

5. Agencement de contact selon la revendication 4, dans lequel, après le soudage, la surface de contact entre le contact et la grille de connexion estampée est plus grande que le plan de section mathématique entre les géométries du contact et de la grille de connexion estampée.

6. Agencement de contact selon la revendication 2, dans lequel le pied de contact est relié au moyen d'un procédé de soudage par faisceau laser ou au moyen d'un procédé de soudage métallique sous gaz inerte.

7. Agencement de contact selon l'une des revendications précédentes, dans lequel la grille de connexion estampée est réalisée sous la forme d'une grille de connexion estampée surmoulée, dans laquelle la surface prévue pour le contact est épargnée par le surmoulage.

8. Agencement de contact selon la revendication 7, dans lequel le surmoulage est réalisé sous la forme d'une couche de matière plastique.

9. Procédé de fabrication d'un agencement de contact électrique (1), comportant les étapes consistant à :
préparer une grille de connexion estampée (3) et un contact de forme allongée (2) ;
disposer le contact (2) perpendiculairement à la grille de connexion estampée (3) ;
réaliser une liaison par matière conductrice (4) entre le contact (2) et la grille de connexion estampée (3),
la liaison (4) étant réalisée au moyen d'un pied de contact (21) formé sur le contact (2) et coudé perpendiculairement à celui-ci, qui s'étend parallèlement à la grille de connexion estampée (3), avec les étapes suivantes consistant à :
faire passer le pied de contact (21) à travers une ouverture (25) dans la grille de connexion estampée (3) et appliquer la surface (23) du pied de contact (21) orientée vers le contact (2) contre la grille de connexion estampée (3) ;
souder le pied de contact (21) à la grille de connexion estampée (3).

10. Procédé selon la revendication 9, dans lequel le pied de contact est soudé à la grille de connexion estampée par soudage par bossages.

11. Procédé selon la revendication 9 ou 10, dans lequel un élément de contact rond, qui a été aplati et coudé dans la zone du pied de contact, est prévu comme contact.
